# EUROPEAN PATENT APPLICATION

(11) **EP 4 783 232 A1**
(43) Date of publication of application: **29.07.2026**
(21) Application number: 24881425.3
(22) Date of filing: 11.10.2024
(51) Int. Cl.: H01L 21/67, C30B 25/10, C30B 31/12

(54) **AUXILIARY HEATING APPARATUS AND SEMICONDUCTOR HEAT TREATMENT DEVICE**

(30) Priority: 26.10.2023 CN 202311402954
(71) Applicant: Beijing NAURA Microelectronics Equipment Co., Ltd., Beijing 100176 (CN)
(72) Inventor: LIU, Hongli, Beijing 100176 (CN); TAN, Ruilei, Beijing 100176 (CN)
(74) Representative: Cohausz & Florack
(86) International application number: PCT/CN2024/124139
(87) International publication number: WO 2025/087059

(57) **Abstract**

The present disclosure provides an auxiliary heating apparatus and a semiconductor heat treatment equipment. The auxiliary heating apparatus includes: a housing, which is capable of being disposed inside a semiconductor heat treatment equipment at a position near a process door during use, and is provided with a mounting cavity; a heating element, which is disposed in the mounting cavity; a cable, which is connected to the heating element, and is configured to be connected to a power supply; and a connector, a first end of the connector being connected to the housing, a second end of the connector being capable of extending out of the semiconductor heat treatment equipment during use, the connector being provided with a wiring channel communicating with the mounting cavity, and the cable being capable of extending out of the semiconductor heat treatment equipment through the wiring channel during use. The auxiliary heating apparatus provided in the present disclosure can increase the number of product wafers processed by a single machine and improve process quality of product wafers.

## Description

### TECHNICAL FIELD

The present disclosure relates to the field of semiconductor manufacturing, and in particular, to an auxiliary heating apparatus for a semiconductor heat treatment equipment, and a semiconductor heat treatment equipment.

### BACKGROUND

A semiconductor heat treatment equipment is core equipment for manufacturing an integrated circuit, and is applied to various processes such as oxidation, annealing, and film growth during manufacturing of the integrated circuit, and a reaction furnace is a core component of the semiconductor heat treatment equipment.

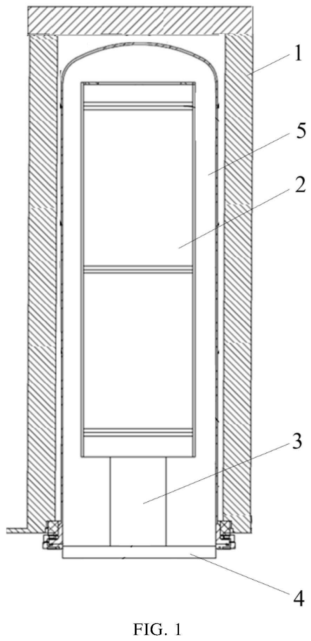

As shown in FIG. 1, a reaction furnace in the existing technology includes: a furnace body 1, a wafer boat 2, an insulation bucket 3, and a process door 4. A reaction chamber 5 is provided inside the furnace body 1, the wafer boat 2 is disposed in the reaction chamber 5, and the process door 4 is disposed at a bottom of the furnace body 1, and the insulation bucket 3 is disposed on the process door 4, and the wafer boat 2 is disposed above the process door 4 and is supported and fixed by the insulation bucket 3. The furnace body 1 provides a reaction temperature for a product wafer by heating.

When the reaction furnace is in use, heat leakage occurs at a bottom of the reaction chamber 5 because the bottom of the reaction chamber 5 is close to a furnace mouth (i.e., a bottom opening of the furnace body 1), such that power of a temperature zone at the bottom of the reaction chamber 5 is the largest in a temperature rise process and a heat preservation process of the furnace body 1, and a lower temperature at the bottom of the reaction chamber 5 leads to a reduction in coverage of a constant temperature zone in the whole reaction chamber 5, which affects not only the number of product wafers processed by a single machine and but also process quality of product wafers located at the bottom of the reaction chamber 5.

### SUMMARY

The present disclosure aims to at least solve the problem of the lower temperature at the bottom of the reaction chamber in the existing technology, and provides an auxiliary heating apparatus for a semiconductor heat treatment equipment and a semiconductor heat treatment equipment.

In order to achieve the objective of the present disclosure, there is provided an auxiliary heating apparatus for a semiconductor heat treatment equipment, including: a housing, which is capable of being disposed inside the semiconductor heat treatment equipment at a position near a process door during use, and is provided with a mounting cavity;
a heating element, which is disposed in the mounting cavity;
a cable, which is connected to the heating element, and is configured to be connected to a power supply; and
a connector, a first end of the connector being connected to the housing, a second end of the connector being capable of extending out of the semiconductor heat treatment equipment during use, the connector being provided with a wiring channel communicating with the mounting cavity, and the cable being capable of extending out of the semiconductor heat treatment equipment through the wiring channel during use.

In some embodiments, the heating element includes a conductive tape, the conductive tape extends in a plane in a rotational or winding manner to form a labyrinth structure, and the plane is parallel to a radial plane of a reaction chamber of the semiconductor heat treatment equipment.

In some embodiments, a support portion is disposed in the mounting cavity, and the conductive tape is supported by the support portion; and
the labyrinth structure is provided with a gap, and the support portion is provided with a limiting structure, which is located in the gap for limiting a position of the conductive tape.

In some embodiments, the limiting structure includes a plurality of stoppers disposed at intervals on the support portion.

In some embodiments, the housing is provided with a connecting hole on a side where the connector is located, and the wiring channel communicates with the mounting cavity through the connecting hole; and
the support portion includes a plurality of reinforcing ribs, which are connected to an inner surface of the housing on a side where the connecting hole is located, and are distributed at intervals along a circumferential direction of the connecting hole; each reinforcing rib has one end located at an edge of the connecting hole and the other end located at an edge of the inner surface; and each reinforcing rib is provided with at least one stopper.

In some embodiments, each reinforcing rib is provided with a plurality of stoppers, which are disposed at intervals along an extension direction of the reinforcing rib; and the stoppers disposed on the plurality of reinforcing ribs are distributed on at least one circle around the connecting hole.

In some embodiments, an end of the conductive tape is located at the connecting hole, and bends towards the interior of the connecting hole, and the cable is connected to the end of the conductive tape.

In some embodiments, the auxiliary heating apparatus further includes:
a temperature detection device, which is provided with a temperature measuring part for detecting a temperature of the heating element;
wherein an installation space is formed between the heating element and an inner surface of the housing on a side where a connecting hole is located, and the temperature measuring part is located in the installation space.

In some embodiments, the housing includes:
a tray, the tray being connected to the connector and provided with an accommodating groove, and the heating element being disposed in the accommodating groove; and
a cover plate, the cover plate being disposed on a side of the tray away from the connector and facing the accommodating groove, and a surface of the cover plate facing the accommodating groove and an inner surface of the accommodating groove forming the closed mounting cavity.

In some embodiments, the auxiliary heating apparatus further includes:
a sealing plug, the sealing plug being disposed at the second end of the connector, at least part of the sealing plug entering and sealing the wiring channel, a wiring hole being formed in the sealing plug, the wiring channel communicating with the wiring hole, and the cable being inserted into the wiring hole and extending out of the connector.

In some embodiments, the connector includes a connecting tube, the wiring channel is formed in the connecting tube, a first end of the connecting tube is connected to the housing, and a second end of the connecting tube extends out of the semiconductor heat treatment equipment; at least part of the sealing plug is inserted into the second end of the connecting tube; and
the connecting tube includes a main section and a connecting section, the main section is connected to the housing through the connecting section, and a tube diameter of the connecting section is larger than a tube diameter of the main section.

In some embodiments, the connector is provided with a first limiting boss, which is configured to be in limit fit with the process door during use to limit a position of the connector in a direction perpendicular to a radial plane of a reaction chamber of the semiconductor heat treatment equipment.

In a second aspect, the present disclosure further provides a semiconductor heat treatment equipment, including: a reaction chamber, which is provided with an open structure; a process door, which is disposed at the open structure for sealing the reaction chamber; and the above auxiliary heating apparatus, which is disposed at the process door and configured to heat a region inside the reaction chamber near the process door.

In some embodiments, the housing is disposed in the reaction chamber; and
the connector penetrates through the process door.

In some embodiments, the connector is provided with a first limiting boss, which is configured to be in limit fit with the process door during use to limit a position of the connector in a direction perpendicular to a radial plane of the reaction chamber.

In some embodiments, a buffer pad is disposed on an outer circumferential wall of a connecting tube and between the first limiting boss and the process door.

In some embodiments, the semiconductor heat treatment equipment further includes:
an insulation bucket, which has a first end connected to the process door and a second end configured to support a wafer boat;
wherein the housing is located on the side of the second end of the insulation bucket, and the connector penetrates through the insulation bucket.

In the auxiliary heating apparatus provided in the present disclosure, the housing can be disposed inside the semiconductor heat treatment equipment at the position near the process door during use, and the heating element is disposed in the mounting cavity of the housing and can supply auxiliary and supplementary heat to a bottom of the reaction chamber of the semiconductor heat treatment equipment, so that the problem of a lower temperature at the bottom of the reaction chamber is solved, coverage of a constant temperature zone inside the reaction chamber is expanded, the number of product wafers processed by a single machine is increased, and process quality of product wafers is improved; moreover, under the condition of a same temperature, power of a temperature zone at the bottom of the reaction chamber can be reduced. On this basis, through the wiring channel of the connector which communicates with the mounting cavity, the cable connected to the heating element can extend out of the semiconductor heat treatment equipment through the wiring channel during use, so that the cable can be led out and connected to an external power supply for supplying power to the heating element inside the semiconductor heat treatment equipment. In addition, by disposing the heating element in the mounting cavity, the mounting cavity can be separated from an interior of the semiconductor heat treatment equipment, so that substances in the mounting cavity can be prevented from polluting the reaction chamber.

By adopting the above auxiliary heating apparatus, the semiconductor heat treatment equipment provided in present disclosure can increase the number of product wafers processed by a single machine and improve process quality of product wafers.

### BRIEF DESCRIPTION OF DRAWINGS

FIG. 1 is a schematic structural diagram of a semiconductor heat treatment equipment in the existing technology;
FIG. 2 is a schematic structural diagram of an auxiliary heating apparatus according to a first embodiment of the present disclosure;
FIG. 3 is a schematic structural diagram of a heating element of an auxiliary heating apparatus according to the first embodiment of the present disclosure;
FIG. 4 is an exploded view of a housing and a heating element of an auxiliary heating apparatus according to the first embodiment of the present disclosure;
FIG. 5 is a sectional view of a tray of an auxiliary heating apparatus according to the first embodiment of the present disclosure;
FIG. 6 is a schematic diagram illustrating cooperation of a tray, a heating element, and a temperature detection device of an auxiliary heating apparatus according to the first embodiment of the present disclosure;
FIG. 7 is an exploded view of a connecting tube and a sealing plug of an auxiliary heating apparatus according to the first embodiment of the present disclosure;
FIG. 8 is a schematic structural diagram of a sealing plug of an auxiliary heating apparatus according to the first embodiment of the present disclosure;
FIG. 9 is a sectional view of a sealing plug of an auxiliary heating apparatus according to the first embodiment of the present disclosure;
FIG. 10 is a sectional view illustrating cooperation of a connecting tube and a sealing plug of an auxiliary heating apparatus according to the first embodiment of the present disclosure; and
FIG. 11 is a schematic structural diagram of a semiconductor heat treatment equipment according to a second embodiment of the present disclosure.

### Reference numerals:

10-housing; 11-tray; 111-support portion; 112-stopper; 113-connecting holes; 114-bottom plate; 115-sidewall; 12-cover plate; 20-heating element; 21-conductive tape; 211-end; 22-gap; 30-cable; 40-connector; 41-connecting tube; 411-wiring channel; 412-main section; 413-connecting section; 414-first step structure; 415-first limiting boss; 416-first limiting hole; 42-sealing plug; 421-wiring hole; 421a-large-diameter section; 421b-small-diameter section; 422-second step structure; 423-second limiting boss; 424-first end face; 425-second end face; 426-protrusion; 427-second limiting hole; 428-wiring groove; 43-buffer pad; 44-seal ring; 50-temperature detection device; 51-thermocouple tube; 511-first tube; 512-second tube; 513-arc-shaped structure; 52-thermocouple; 521-temperature measuring part; 60-inner sheath; 70- outer sheath; 80-heat-shrink sleeving; 90-limiting member; 100-furnace body; 110-reaction chamber; 200-process door; 300-auxiliary heating apparatus; 400-insulation bucket; 500-wafer boat.

### DETAIL DESCRIPTION OF EMBODIMENTS

In order to enable those of ordinary skill in the art to better understand the technical solutions of the present disclosure, an auxiliary heating apparatus for a semiconductor heat treatment equipment and a semiconductor heat treatment equipment provided in the present disclosure are described in detail below with reference to the drawings.

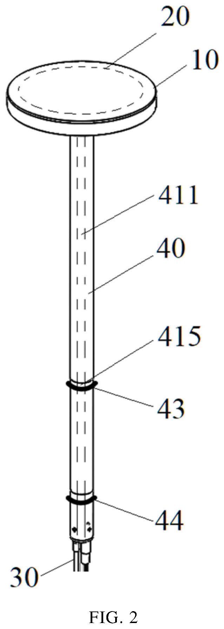

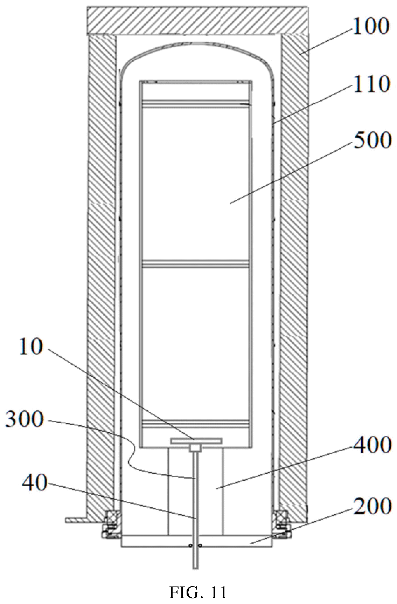

A first embodiment illustrated by FIG. 2 provides an auxiliary heating apparatus for a semiconductor heat treatment equipment, which includes: a housing 10, a heating element 20, a cable 30, and a connector 40. The housing 10 may be disposed inside the semiconductor heat treatment equipment at a position near a process door 200 (see FIG. 11) during use, and is provided with a mounting cavity; the heating element 20 is disposed in the mounting cavity; the cable 30 is connected to the heating element 20, and is configured to be connected to a power supply; a first end of the connector 40 is connected to the housing 10, a second end of the connector 40 may extend out of the semiconductor heat treatment equipment during use, the connector 40 is provided with a wiring channel 411 communicating with the mounting cavity, and the cable 30 may extend out of the semiconductor heat treatment equipment through the wiring channel 411 during use. The above term "during use" refers to that the auxiliary heating apparatus is in a use state after being mounted to the semiconductor heat treatment equipment. It should be noted that the housing 10 in the embodiment of the present disclosure can be disposed inside the semiconductor heat treatment equipment at the position near the process door 200 (see FIG. 11) during use, but the embodiments of the present disclosure are not limited thereto. In practical applications, provided that installation conditions permit, the housing 10 may be disposed at other positions of the semiconductor heat treatment equipment which need heating during use.

In an embodiment, during use, the auxiliary heating apparatus 300 may be disposed in the semiconductor heat treatment equipment and connected to the semiconductor heat treatment equipment with the connector 40, and the housing 10 having the heating element 20 disposed therein may be located inside the semiconductor heat treatment equipment at the position near the process door 200 (see FIG. 11), in which case the cable 30 connected to the heating element 20 may be led out of the semiconductor heat treatment equipment through the wiring channel 411 and connected to an external power supply, so as to supply power to the heating element 20. By disposing the housing 10 inside the semiconductor heat treatment equipment at the position near the process door 200 (see FIG. 11) during use, a region (i.e., a bottom of the reaction chamber 110) inside the semiconductor heat treatment equipment near the process door 200 can be heated by the heating element 20, so that the heating element 20 can assist in supplementing heat to the bottom of the reaction chamber 110 while the furnace body 100 (see FIG. 11) heats the reaction chamber 110, which can expand coverage of a constant temperature zone inside the reaction chamber 110, increase the number of product wafers processed by a single machine, and improve process quality of product wafers.

In the auxiliary heating apparatus 300 provided in the present disclosure, the housing 10 can be disposed inside the semiconductor heat treatment equipment at the position near the process door 200 during use, and the heating element 20 is disposed in the mounting cavity of the housing 10 and can supply auxiliary and supplementary heat to the bottom of the reaction chamber 110 of the semiconductor heat treatment equipment, so that the problem of a lower temperature at the bottom of the reaction chamber 110 is solved, the coverage of the constant temperature zone inside the reaction chamber 110 is expanded, the number of product wafers processed by a single machine is increased, and the process quality of product wafers is improved; moreover, under the condition of a same temperature, power of a temperature zone at the bottom of the reaction chamber 110 can be reduced. On this basis, through the wiring channel 411 of the connector 40 which communicates with the mounting cavity, the cable 30 connected to the heating element 20 can extend out of the semiconductor heat treatment equipment through the wiring channel 411 during use, so that the cable 30 can be led out and connected to the external power supply for supplying power to the heating element 20 inside the semiconductor heat treatment equipment. In addition, by disposing the heating element 20 in the mounting cavity, the mounting cavity can be separated from an interior of the semiconductor heat treatment equipment, so that substances in the mounting cavity can be prevented from polluting the reaction chamber.

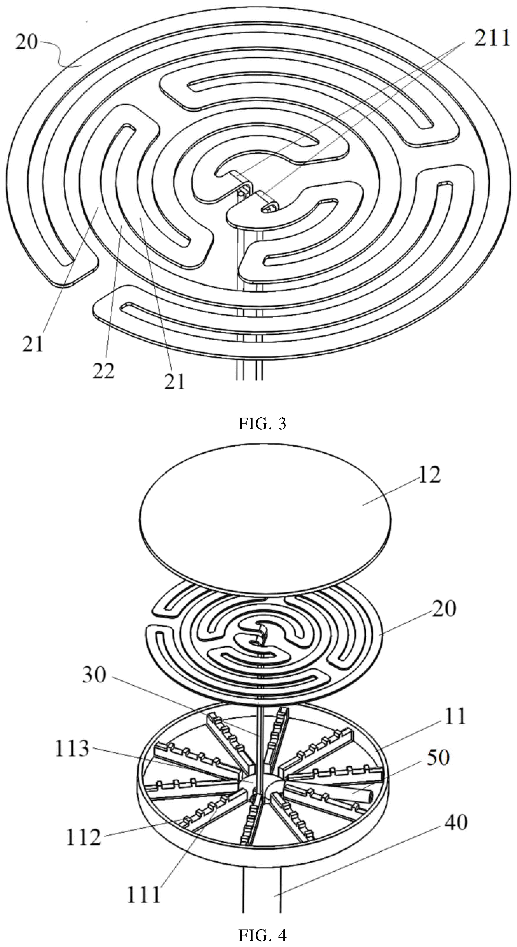

In some embodiments, as shown in FIG. 3, the heating element 20 includes, for example, a conductive tape 21, and the conductive tape 21 extends in a plane in a rotational or winding manner to form a labyrinth structure. The plane is parallel to a radial plane of the reaction chamber 110 (see FIG. 11) of the semiconductor heat treatment equipment. By adopting such structure, the heating element 20 can have increased heating area and generate a uniform thermal field, thereby improving heating effect and heating efficiency. Referring to FIG. 3, in the present embodiment, the heating element 20 is sheet-like and is made of an electrothermal alloy; and the conductive tape 21 of the heating element 20 is distributed in the form of a circular labyrinth, so that a length of the conductive tape 21 can be effectively increased, and thus a larger heating length and a larger radiation area can be provided, resulting in an increase in heating area of the heating element.

It should be noted that although the heating element 20 includes the conductive tape 21 and the conductive tape 21 extends in the plane in a rotational or winding manner to form the labyrinth structure as in the first embodiment, those are not restrictive. In some other embodiments not illustrated by the drawings, the heating element 20 may be formed into other structures, for example, the heating element 20 may be in the form of a spiral heating wire. That is, any component capable of being powered to heat a surrounding zone falls within the scope of the present disclosure. Compared with the other structures, the heating element 20 provided in the present embodiment can provide a product wafer with a planar radiation zone which is not only larger in heating area but also facilitates a more uniform thermal field at the bottom of the reaction chamber 110.

As shown in FIG. 4, in some embodiments, the housing 10 includes, for example, a tray 11 and a cover plate 12. The tray 11 is connected to the connector 40, and the heating element 20 is disposed in the tray 11. In an embodiment, the tray 11 is provided with an accommodating groove, and the heating element 20 is disposed in the accommodating groove; the cover plate 12 is disposed above the tray 11, and the cover plate 12 and the tray 11 enclose the closed mounting cavity. That is, the cover plate 12 is disposed on a side of the tray 11 away from the connector 40 and faces the accommodating groove, and a surface of the cover plate 12 facing the accommodating groove and an inner surface of the accommodating groove form the closed mounting cavity. By providing the tray 11 and the cover plate 12 to form the closed mounting cavity and disposing the heating element 20 in the mounting cavity, the mounting cavity is separated from the interior of the reaction chamber 110 (see FIG. 11), so that the substances in the mounting cavity can be prevented from polluting the reaction chamber 110. Moreover, the housing 10 is generally in a shape of a relatively flat cylinder, and an end face of the housing 10 may cooperate with the heating element 20 to form a heating surface, and the heating surface may face a bottom of a wafer boat 500 during heating to effectively heat the bottom of the wafer boat 500, so as to improve the heating effect.

It should be noted that in the present embodiment, the connector 40, the tray 11, and the cover plate 12 are made of quartz and are connected together by fusion welding. Due to the use of quartz, the connector 40, the tray 11, and the cover plate 12 can resist a high temperature, have good permeability, and can transmit radiant heat well.

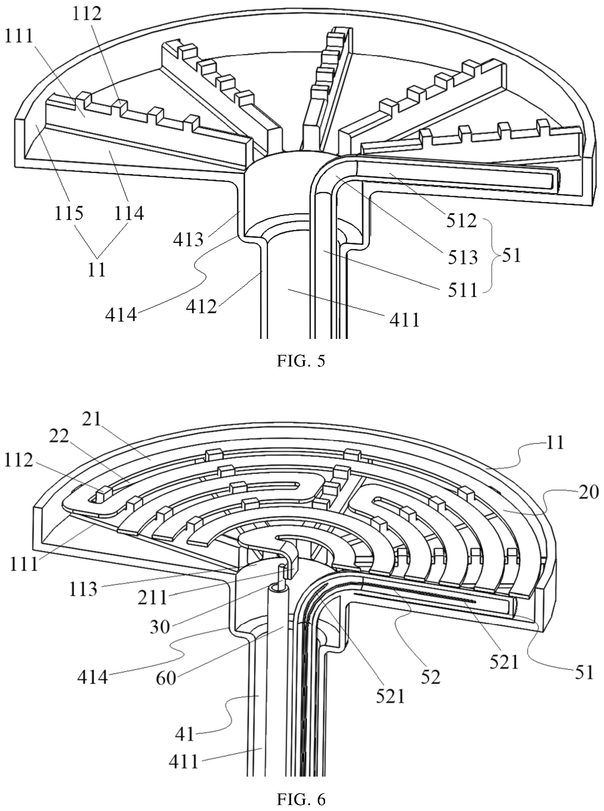

In some embodiments, as shown in FIG. 4 and FIG. 5, a support portion 111 is disposed in the mounting cavity, and the conductive tape 21 is supported by the support portion 111; moreover, the labyrinth structure is provided with a gap, and the support portion 111 is provided with a limiting structure, which is located in the gap for limiting a position of the conductive tape 21. As shown in FIG. 6, the conductive tape 21 is disposed on the support portion 111. The support portion 111 is configured to support the conductive tape 21 to make the conductive tape 21 closer to an inner surface of the housing 10 on a side away from the connector 40 (for example, closer to an inner surface of the cover plate 12), so that a heat transfer distance can be reduced, and heat can be easily transferred to a target position. Meanwhile, the conductive tape 21 is farther from an inner surface of the housing 10 (e.g., an inner surface of a bottom plate 114) on a side where the connector 40 is located, and a mounting space is formed between the heating element 20 and the inner surface of the housing 10 (e.g., the inner surface of the bottom plate 114) on the side where the connector 40 is located, and may be used for installation of other components. As can be seen, by disposing the support portion 111, a strengthen of the housing 10 can be enhanced, the heating effect can be improved, and the installation space can be optimized.

In addition, as shown in FIG. 6, after the conductive tape 21 is mounted on the support portion 111, the position of the conductive tape 21 can be limited by disposing the limiting structure of the support portion 111 in the gap of the labyrinth structure, so that the position of the conductive tape 21 is relatively fixed, and the conductive tape 21 is prevented from shaking to cause poor contact.

The limiting structure capable of performing the above function may be in various forms. For example, the limiting structure includes a plurality of stoppers 112 disposed at intervals on the support portion 111. Each stopper 112 is located in the gap of the labyrinth structure to play a role in limiting the position of the conductive tape 21. Meanwhile, every two adjacent stoppers 12 may clamp and fix the conductive tape 21 therebetween, thereby preventing the conductive tape 21 from shaking to cause poor contact.

In some embodiments, the housing 10 is provided with a connecting hole 113 on the side where the connector 40 is located (for example, on the bottom plate 114), and the wiring channel 411 communicates with the mounting cavity in the housing 10 through the connecting hole 113. On this basis, as shown in FIG. 5, the support portion 111 includes a plurality of reinforcing ribs, which are connected to the inner surface of the housing 10 (e.g., the inner surface of the bottom plate 114) on the side where the connecting hole 113 is located, and are distributed at intervals along a circumferential direction of the connecting hole 113; each reinforcing rib has one end located at an edge of the connecting hole 113 and the other end located at an edge of the inner surface of the housing 10 (e.g., the inner surface of the bottom plate 114) on the side where the connecting hole 113 is located, that is, the plurality of reinforcing ribs are distributed to form a spoke-like structure. Each reinforcing rib is provided with at least one stopper 112.

In an embodiment, taking the housing 10 including the tray 11 and the cover plate 12 as an example, as shown in FIG. 4, the tray 11 includes the circular bottom plate 114 and a sidewall 115 disposed at an edge of the bottom plate 114 along a circumferential direction, the connecting hole 113 is disposed at a central position of the bottom plate 114, the connector 40 is connected, from the outside of the bottom plate 114, to the bottom plate 114 at a position corresponding to the connecting hole 113, and the wiring channel 411 of the connector 40 communicates with the connecting hole 113 to further communicate with the mounting cavity through the connecting hole 113.

As shown in FIG. 5, the support portion 111 is a reinforcing rib connected to the bottom plate 114, a first end of the support portion 111 is located at the edge of the connecting hole 113, and a second end of the support portion 111 is located at the edge of the inner surface of the housing 10 (e.g., the inner surface of the bottom plate 114) on the side where the connecting hole 113 is located, and is connected to an inner side of the sidewall 115. A plurality of stoppers 112 protruding in a direction towards the inner surface of the cover plate 12 are disposed on the support portion 111, and are disposed at intervals along an extension direction of the support portion 111, and a fixing space for fixing the conductive tape 21 is formed between adjacent stoppers 112. Meanwhile, the number of support portions 111 is more than one, and a plurality of support portions 111 are circumferentially distributed at intervals to form a spoke-like structure.

As shown in FIG. 6, the conductive tape 21 is disposed on the support portion 111. The support portion 111 is configured to support the conductive tape 21 to make the conductive tape 21 closer to the cover plate 12, so as to reduce the heat transfer distance and facilitate heat transfer to a target position. Meanwhile, the conductive tape 21 is farther from the bottom plate 114, and the installation space is formed between the conductive tape 21 and the bottom plate 114 of the tray 11, and may be used for installation of other components. As can be seen, by disposing the support portion 111, a strengthen of the bottom plate 10 can be enhanced, the heating effect can be improved, and the installation space can be optimized.

In addition, as shown in FIG. 6, after the conductive tape 21 is mounted on the support portion 111, the conductive tape 21 is located in the fixing space, that is, different positions of the conductive tape 21 are respectively subjected to clamping and fixing by a plurality of stoppers112, so that a position of the heating element 20 is relatively fixed, and the heating element 20 is prevented from shaking to cause poor contact.

It should be noted that in an embodiment, as shown in FIG. 3 and FIG. 6, the labyrinth structure formed by the heating element 20 is generally circular, the conductive tape 21 forms a plurality of arc sections with different lengths by winding or rotational extension, and all the arc sections are located in a same plane and have a same center, that is, all circles where the arc sections are respectively located are concentric circles. The arc sections on different circles are distributed at intervals from inside to outside, and the arc sections on a same circle are circumferentially distributed at intervals, thereby forming the labyrinth structure. In the labyrinth structure, a gap 22, i.e., the gap of the labyrinth structure, is formed between two arc sections which are adjacent to each other in a radial direction. On this basis, in some embodiments, in order to perform a limiting function on all the conductive tape 21 on the different circles, the stoppers 112 disposed on the plurality of reinforcing ribs are distributed on at least one circle around the connecting hole 113. In this way, all the stoppers 112 on a same circle can be located in a same gap 22 corresponding to the circle, so as to separate the arc sections of the conductive tape 21 which are adjacent to each other in the radial direction, thereby performing radial separation and insulation functions; moreover, it can be ensured that the arc sections of the conductive tape 21 which are adjacent to each other in the radial direction can be separated at all positions in the circumferential direction. The conductive tape 21 expands and deforms at a high temperature due to thermal expansion and contraction, such that the gap 22 between the two arc sections which are adjacent to each other in the radial direction is reduced, or the two arc sections which are adjacent to each other in the radial direction may even contact each other, causing a short circuit. By providing the stoppers 112, the contact between the adjacent arc sections of the conductive tape 21 caused by thermal deformation of the conductive tape 21 can be effectively avoided, which improves reliability of the auxiliary heating apparatus 300.

In some embodiments, in order to reduce welding stress and improve connection reliability, an end of the conductive tape 21 is located at the connecting hole 113, and bends towards the interior of the connecting hole 113, and the cable 30 is connected to the end of the conductive tape 21. In an embodiment, as shown in FIG. 3, two ends 211 of the conductive tape 21 are located at a central position of the integral heating element 20. As can be seen from FIG. 6, the ends 211 of the conductive tape 21 are just located at the connecting hole 113, and bends towards the interior of the connecting hole 113, and the cables 30 are welded to the ends 211 of the conductive tape 21. In this way, the welding stress can be reduced.

As shown in FIG. 4 and FIG. 6, the auxiliary heating apparatus 300 further includes: a temperature detection device 50, which is provided with a temperature measuring part 521 for detecting a temperature of the heating element 20; and the temperature measuring part 521 is located in the installation space (i.e., the installation space formed between the heating element 20 and the inner surface of the housing 10 (e.g., the inner surface of the bottom plate 114) on the side where the connecting hole 113 is located), which can facilitate control of temperature monitoring.

In an embodiment, as shown in FIG. 6, the temperature detection device 50 includes: a thermocouple tube 51 and a thermocouple 52. The thermocouple tube 51 is provided with a first tube 511 and a second tube 512 connected to each other. The first tube 511 is disposed through the wiring channel 411, the second tube 512 is located in the installation space, and an included angle is formed between an axis of the first tube 511 and an axis of the second tube 512; and the thermocouple 52 is disposed in the thermocouple tube 51, and is provided with the temperature measuring part 521 located in the second tube 512, that is, the temperature measuring part 521 of the thermocouple 52 is located in the installation space between the heating element 20 and the bottom plate 114, so that temperature monitoring may be performed on the heating element 20. A first end of the first tube 511 is an open end, a first end of the second tube 512 is connected to a second end of the first tube 511, for example, the first end of the second tube 512 and the second end of the first tube 511 are connected together, and an interior of the second tube 512 communicates with an interior of the first tube 511; and a second end of the second tube 512 is a closed end, and a buffer space is formed between the temperature measuring part 521 and the closed end of the second tube 512. By providing the buffer space between the temperature measuring part 521 of the thermocouple 52 and the closed end of the second tube 512, the problem of inaccurate temperature measurement caused by the thermocouple 52 extending due to thermal expansion at a high temperature and touching the thermocouple tube 51 can be avoided. Thus, temperature measurement accuracy can be effectively improved.

In addition, in the present embodiment, an arc-shaped structure 513 is disposed at a connection position between the first tube 511 and the second tube 512. During assembly, the thermocouple 52 needs to be inserted into the first tube 511 and the second tube 512 sequentially from the open end of the first tube 511; and by providing the arc-shaped structure 513, the thermocouple 52 can easily enter the second tube 512 from the first tube 511, which improves assembly efficiency.

After assembly and the heating element 20 is powered to generate heat, the heat is radiated to the temperature measuring part 521 of the thermocouple 52, the thermocouple 52 feeds an acquired temperature signal back to a controller, and the controller adjusts a heating power of the heating element 20 to increase or reduce a temperature; when the temperature exceeds a set limit, the controller may cut off the power to protect the heating element 20 and avoid over-temperature of the whole apparatus. The thermocouple tube 51 can isolate and protect the thermocouple 52.

It should be understood that the number of temperature measuring parts 521 of the thermocouple 52 may be one or more. In the present embodiment, as shown in FIG. 6, the thermocouple 52 is provided with two temperature measuring parts 521, one of the two temperature measuring parts 521 is located at a position near the sidewall 115 of the tray 11 to measure a temperature at an edge of the heating element 20, and the other of the two temperature measuring parts 521 is located at the connecting hole 113 to measure a temperature at a position near a center of the heating element 20. In the present embodiment, the thermocouple tube 51 is made of quartz.

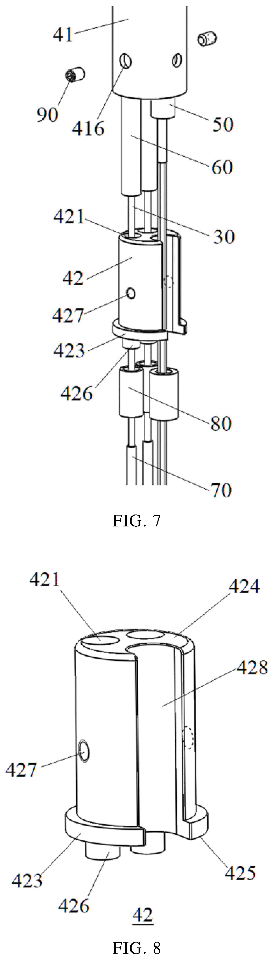

In some embodiments, as shown in FIG. 7, the auxiliary heating apparatus further includes: a sealing plug 42 disposed at the second end of the connector 40, at least part of the sealing plug 42 enters and seals the wiring channel 411, a wiring hole 421 is formed in the sealing plug 42, the wiring channel 411 communicates with the wiring hole 421, and the cable 30 is inserted into the wiring hole 421 and extends out of the connector 40. The second end of the connector 40 can be plugged by disposing the sealing plug 42 at the second end of the connector 40. The sealing plug 42 is made of, for example, high-temperature-resistant high-strength plastic, and the sealing plug 42 may also function to support the thermocouple 51.

On this basis, further, in some embodiments, the connector 40 includes a connecting tube 41 having the wiring channel 411 formed therein, a first end of the connecting tube 41 is connected to the housing 10, and a second end of the connecting tube 41 extends out of the semiconductor heat treatment equipment; at least part of the sealing plug 42 is inserted into the second end of the connecting tube 41, that is, at least part of the sealing plug 42 is located in the wiring channel 411, the wiring hole 421 is formed in the sealing plug 42, the wiring channel 411 communicates with the wiring hole 421, the cable 30 is inserted into the wiring hole 421 and extends out of the connecting tube 41, and the thermocouple tube 51 penetrates through the sealing plug 42 and extends out of the connecting tube 41.

In the present embodiment, the connecting tube 41 is made of quartz; and by providing the connecting tube 41, the whole auxiliary heating apparatus 300 can be supported; meanwhile, the wiring channel 411 inside the connecting tube 41 can effectively protect the cable 30 and guide the cable 30 out of the semiconductor heat treatment equipment.

In some embodiments, as shown in FIG. 5 and FIG. 6, the connecting tube 41 includes a main section 412 and a connecting section 413, the main section 412 is connected to the housing 10 (e.g., the bottom plate 114 of the tray 11) through the connecting section 413, and a tube diameter of the connecting section 413 is larger than that of the main section 412 to form a first step structure 414. The connecting section 413 enables the connection between the main section 412 and the housing 10 (e.g., the bottom plate 114 of the tray 11), thereby playing a transition role. On the one hand, since the tube diameter of the connecting section 413 is larger, connecting area between the connecting section 413 and the housing 10 is larger, stress at a connection is dispersed, and the connection between the connector 40 and the housing 10 can be free from fracture and damage caused by over concentration of the stress. In addition, due to the larger tube diameter of the connecting section 413, an inner space of the connecting section 413 is larger, which facilitates installation of the cable 30 and the temperature detection device 50.

In some embodiments, as shown in FIG. 2, the connector 40 (e.g., the connecting tube 41) is provided with a first limiting boss 415, which is used for limit fit with the process door 200 during use to limit a position of the connector 40 (e.g., the connecting tube 41) in a direction perpendicular to the radial plane of the reaction chamber 110 of the semiconductor heat treatment equipment. In an embodiment, the first limiting boss 415 is disposed on an outer circumferential wall of the connector 40 (e.g., the connecting tube 41), and is used for position limiting in an axial direction of the connector 40 (e.g., the connecting tube 41). The first limiting boss 415 is, for example, located on the main section 412. As shown in FIG. 11, when the auxiliary heating apparatus 300 is mounted to the process door 200 provided with a mounting hole, the connector 40 (e.g., the connecting tube 41) is inserted into the mounting hole; since an outer diameter of the first limiting boss 415 is larger than an inner diameter of the mounting hole, the first limiting boss 415 just sticks on an inner wall surface of the process door 200 to limit axial displacement of the connecting tube 41, that is, to realize position limiting in a vertical direction shown in FIG. 11, so as to avoid falling and axial movement of the auxiliary heating apparatus 300 due to its own gravity. In order to avoid wear of the first limiting boss 415 and the process door 200, in some embodiments, a buffer pad 43 is disposed on an outer circumferential wall of the connecting tube 41 and between the first limiting boss 415 and the process door 200.

It should be understood that in order to improve sealing performance, the connecting tube 41 is sealed to the process door 200. In the present embodiment, a seal ring 44 is mounted to the outer circumferential wall of the connecting tube 41, so as to seal the connecting tube 41 to the process door 200, thereby separating the reaction chamber 110 from an external environment.

In an embodiment, as shown in FIG. 8, the sealing plug 42 is cylindrical and has an outer circumferential surface matched with an inner wall surface of the wiring channel 411, and the sealing plug 42 has a first end and a second end opposite to each other in an axial direction.

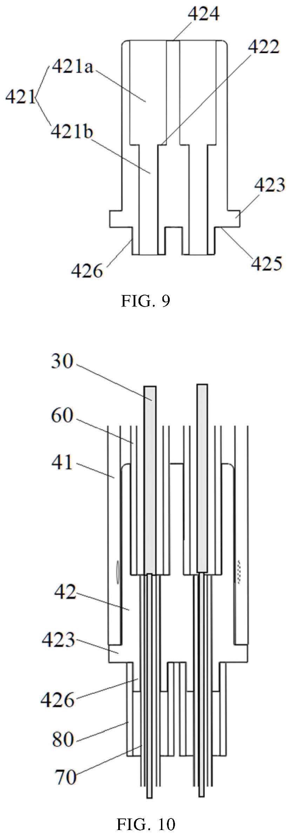

In an embodiment, as shown in FIG. 10, the first end of the sealing plug 42 is located in the connecting tube 41, a second limiting boss 423 is disposed on an outer circumferential wall of the sealing plug 42 at a position near the second end of the sealing plug 42, and the second end of the connecting tube 41 abuts against the second limiting boss 423, so as to achieve limit fit of the connecting tube 41 and the sealing plug 42 in the axial direction. The second end of the connecting tube 41 can be plugged by disposing the sealing plug 42 at the second end of the connecting tube 41. The sealing plug 42 is made of high-temperature-resistant high-strength plastic, and functions to support the thermocouple tube 51. In addition, with the second limiting boss 423, the sealing plug 42 can be prevented from completely entering the connecting tube 41, so that the sealing plug 42 can be easily taken out.

As shown in FIG. 9, the first end of the sealing plug 42 has a first end face 424, the second end of the sealing plug 42 has a second end face 425, a protrusion 426 is disposed on the second end face 425, the first end of the wiring hole 421 is located on the first end face 424, and the second end of the wiring hole 421 is located on an end face of the protrusion 426. The wiring hole 421 is divided into a large-diameter section 421a and a small-diameter section 421b in sequence in a direction from the first end to the second end, and a second step structure 422 is formed on an inner circumferential wall of the wiring hole 421 at a connection position of the large-diameter section 421a and the small-diameter section 421b.

As shown in FIG. 7 and FIG. 10, the auxiliary heating apparatus 300 further includes: an inner sheath 60, an outer sheath 70, and a heat-shrink sleeve 80. The inner sheath 60 is inserted into the connecting tube 41, the cable 30 is inserted into the inner sheath 60, and the inner sheath 60 is configured to protect the cable 30. In the present embodiment, the cable 30 is in a shape of a round rod, and the inner sheath 60 is disposed outside the cable 30, and is made of a ceramic material to perform thermal insulation and electric insulation functions.

As shown in FIG. 6, a first end of the inner sheath 60 extends to a connection position of the cable 30 and the heating element 20, so as to protect the cable 30 to the greatest extent and achieve effective electric insulation. As shown in FIG. 10, a second end of the inner sheath 60 abuts against the second step structure 422, so that the inner sheath 60 may be supported by the second step structure 422 in an axial direction of the wiring hole 421.

As shown in FIG. 7 and FIG. 10, the outer sheath 70 is configured to protect a portion of the cable 30 which is located outside the connecting tube 41, a first end of the outer sheath 70 is inserted into the small-diameter section 421b of the wiring hole 421, and the cable 30 is inserted into the outer sheath 70; and the heat-shrink sleeve 80 is sleeved over both the protrusion 426 and the outer sheath 70, and is configured to fix relative positions of the protrusion 426 and the outer sheath 70. During use, the heat-shrink sleeve 80 is sleeved over the protrusion 426, and after being heated, the heat-shrink sleeve 80 may wrap the outer sheath 70 and the protrusion 426, so as to fix the outer sheath 70, the cable 30, and the sealing plug 42 relative to each other, and prevent the outer sheath 70, the cable 30, and the sealing plug 42 from moving vertically.

As shown in FIG. 8, a wiring groove 428 is formed in an outer wall of the sealing plug 42, two ends of the wiring groove 428 extend to the first end and the second end of the sealing plug 42 respectively, and the thermocouple tube 51 is inserted into the wiring groove 428 to extend out of the connecting tube 41. Meanwhile, the sealing plug 42 is in tight fit with the thermocouple tube 51 to axially support the thermocouple tube 51.

As shown in FIG. 7, the auxiliary heating apparatus 300 further includes: a limiting member 90 penetrating through an inner wall of the connecting tube 41; meanwhile, part of the limiting member 90 is located in the sealing plug 42, and the connecting tube 41 and the sealing plug 42 are limited and fixed with the limiting member 90. A first limiting hole 416 is formed in an outer wall of the connecting tube 41, and penetrates through a tube wall of the connecting tube 41, a second limiting hole 427 is formed in the outer wall of the sealing plug 42, the first limiting hole 416 corresponds to the second limiting hole 427, and the limiting member 90 is located in both the first limiting hole 416 and the second limiting hole 427. In the present embodiment, the first limiting hole 416 and the second limiting hole 427 are both threaded holes, and the limiting member 90 is a bolt. During use, after the sealing plug 42 is inserted into the connecting tube 41, the first limiting hole 416 is aligned with the second limiting hole 427, the bolt is inserted into the first limiting hole 416 and turned to make part of the bolt enter the second limiting hole 427, so that the sealing plug 42 and the connecting tube 41 are relatively fixed, and tightness and reliability of the fit of the sealing plug 42 and the connecting tube 41 are improved.

In the above embodiments, the housing 10, the connector 40, and the thermocouple tube 51 are all made of quartz. However, the present disclosure is not limited thereto. The housing 10, the connector 40, and the thermocouple tube 51 may be made of other high-temperature resistant materials.

As shown in FIG. 11, a second embodiment of the present disclosure provides a semiconductor heat treatment equipment, including: a reaction chamber 110, a process door 200, and the auxiliary heating apparatus 300 provided in the embodiments of the present disclosure. The reaction chamber 110 is provided with an open structure; and the process door 200 is disposed at the open structure for sealing the reaction chamber 110. The auxiliary heating apparatus 300 is disposed at the process door 200, and is configured to heat a region inside the reaction chamber 110 near the process door 200.

By adopting the auxiliary heating apparatus provided in the embodiments of the present disclosure, the semiconductor heat treatment equipment provided in the embodiment of the present disclosure can increase the number of product wafers processed by a single machine and improve process quality of product wafers.

In an embodiment, the semiconductor heat treatment equipment includes a furnace body 100, the reaction chamber 110, the process door 200, an insulation bucket 400, a wafer boat 500, and the auxiliary heating apparatus 300. The reaction chamber 110 is disposed inside the furnace body 100, the furnace body 100 is configured to heat the reaction chamber 110 disposed therein, a bottom of the reaction chamber 110 is provided with the open structure, the process door 200 is disposed at the open structure for sealing the reaction chamber 110, and the wafer boat 500 is disposed in the reaction chamber 110; and a first end of the insulation bucket 400 is connected to the process door 200, and a second end of the insulation bucket 400 supports a bottom of the wafer boat 500.

The auxiliary heating apparatus 300 is disposed at the process door 200, and is configured to heat the region inside the reaction chamber 110 near the process door 200.

During use, by heating the region inside the semiconductor heat treatment equipment near the process door 200 and the bottom of the wafer boat 500 with the heating element 20, auxiliary and supplementary heat can be supplied to the bottom of the reaction chamber 110 of the semiconductor heat treatment equipment, so that the problem of a lower temperature at the bottom of the reaction chamber 110 is solved, coverage of a constant temperature zone inside the reaction chamber 110 is expanded, the number of product wafers processed by a single machine is increased, and the process quality of product wafers is improved; moreover, under the condition of a same temperature, power of a temperature zone at the bottom of the reaction chamber 110 can be reduced.

In an embodiment, the housing 10 is provided with the mounting cavity, the heating element 20 is disposed in the mounting cavity, and the housing 10 is disposed inside the reaction chamber 110 at the position near the process door 200, and is located on the side of the second end of the insulation bucket 400 (i.e., an upper side of the insulation bucket 400 in FIG. 11).

The connecting tube 41 penetrates through both the process door 200 and the insulation bucket 400, and has the first end connected to the housing 10 and the second end located outside the reaction chamber 110, and the wiring channel 411 is disposed in the connecting tube 41, and has one end communicating with the mounting cavity and the other end communicating with the outside of the semiconductor heat treatment equipment; and the connecting tube 41 is provided with the first limiting boss 415, and is in limit fit with the process door 200 through the first limiting boss 415 in a vertical direction of the furnace body 100.

The cable 30 is connected to the heating element 20, and is configured to be connected to the power supply; and the cable 30 is inserted into the wiring channel 411, and extends out of the semiconductor heat treatment equipment.

It should be noted that in order to improve the heating effect, as shown in FIG. 3, the heating element 20 includes the conductive tape 21, which extends in a plane in a rotational or winding manner to form the labyrinth structure, with the plane being a radial plane of the furnace body 100. Since the plane in which the conductive tape 21 extends in a rotational manner is the radial plane of the furnace body 100, a heating surface such formed is parallel to the radial plane of the furnace body 100 and an arrangement direction of a wafer, so that the heating element 20 has an increased heating surface and can generate a uniform thermal field, which facilitates heating of the wafer and thus improves heating effect and heating efficiency.

It should be further noted that in the present embodiment, the insulation bucket 400 and the process door 200 are relatively rotatable, and the insulation bucket 400 rotates to drive the wafer boat 500 to rotate, so that the wafer can be heated uniformly. Therefore, in the present embodiment, a gap is provided between the housing 10 and the insulation bucket 400, and a gap is also provided between the connector 40 and the insulation bucket 400, so as to prevent friction or collision between the auxiliary heating apparatus 300 and the insulation bucket 400.

It should be understood that in the present embodiment, an accommodating space for accommodating the housing 10 is formed between the insulation bucket 400 and the wafer boat 500 when the insulation bucket 400 supports the wafer boat 500. For example, the insulation bucket 400 may be provided with support columns, which support the bottom of the wafer boat to form the accommodating space, so as to prevent the auxiliary heating apparatus 300 from contacting the wafer boat 500 to cause friction or collision.

It should be understood that the above implementations are just exemplary implementations adopted to illustrate the principle of the present disclosure, and the present disclosure is not limited thereto. Various modifications and improvements can be made by those of ordinary sill in the art without departing from the spirit and essence of the present disclosure, and those modifications and improvements are also considered to fall within the scope of the present disclosure.

## Claims

1. An auxiliary heating apparatus for a semiconductor heat treatment equipment, comprising:
a housing, which is capable of being disposed inside the semiconductor heat treatment equipment at a position near a process door during use, and is provided with a mounting cavity;
a heating element, which is disposed in the mounting cavity;
a cable, which is connected to the heating element, and is configured to be connected to a power supply; and
a connector, a first end of the connector being connected to the housing, a second end of the connector being capable of extending out of the semiconductor heat treatment equipment during use, the connector being provided with a wiring channel communicating with the mounting cavity, and the cable being capable of extending out of the semiconductor heat treatment equipment through the wiring channel during use.

2. The auxiliary heating apparatus of claim 1, wherein
the heating element comprises a conductive tape, the conductive tape extends in a plane in a rotational or winding manner to form a labyrinth structure, and the plane is parallel to a radial plane of a reaction chamber of the semiconductor heat treatment equipment.

3. The auxiliary heating apparatus of claim 2, wherein a support portion is disposed in the mounting cavity, and the conductive tape is supported by the support portion; and
the labyrinth structure is provided with a gap, and the support portion is provided with a limiting structure, which is located in the gap for limiting a position of the conductive tape.

4. The auxiliary heating apparatus of claim 3, wherein the limiting structure comprises a plurality of stoppers disposed at intervals on the support portion.

5. The auxiliary heating apparatus of claim 4, wherein the housing is provided with a connecting hole on a side where the connector is located, and the wiring channel communicates with the mounting cavity through the connecting hole; and
the support portion comprises a plurality of reinforcing ribs, which are connected to an inner surface of the housing on a side where the connecting hole is located, and are distributed at intervals along a circumferential direction of the connecting hole; each reinforcing rib has one end located at an edge of the connecting hole and the other end located at an edge of the inner surface; and each reinforcing rib is provided with at least one stopper.

6. The auxiliary heating apparatus of claim 5, wherein each reinforcing rib is provided with a plurality of stoppers, which are disposed at intervals along an extension direction of the reinforcing rib; and the stoppers disposed on the plurality of reinforcing ribs are distributed on at least one circle around the connecting hole.

7. The auxiliary heating apparatus of claim 5, wherein an end of the conductive tape is located at the connecting hole, and bends towards the interior of the connecting hole, and the cable is connected to the end of the conductive tape.

8. The auxiliary heating apparatus of any one of claims 1 to 7, further comprising:
a temperature detection device, which is provided with a temperature measuring part for detecting a temperature of the heating element;
wherein an installation space is formed between the heating element and an inner surface of the housing on a side where a connecting hole is located, and the temperature measuring part is located in the installation space.

9. The auxiliary heating apparatus of any one of claims 1 to 7, wherein the housing comprises:
a tray, the tray being connected to the connector and provided with an accommodating groove, and the heating element being disposed in the accommodating groove; and
a cover plate, the cover plate being disposed on a side of the tray away from the connector and facing the accommodating groove, and a surface of the cover plate facing the accommodating groove and an inner surface of the accommodating groove forming the closed mounting cavity.

10. The auxiliary heating apparatus of any one of claims 1 to 7, further comprising:
a sealing plug, the sealing plug being disposed at the second end of the connector, at least part of the sealing plug entering and sealing the wiring channel, a wiring hole being formed in the sealing plug, the wiring channel communicating with the wiring hole, and the cable being inserted into the wiring hole and extending out of the connector.

11. The auxiliary heating apparatus of claim 10, wherein the connector comprises a connecting tube, the wiring channel is formed in the connecting tube, a first end of the connecting tube is connected to the housing, and a second end of the connecting tube extends out of the semiconductor heat treatment equipment; at least part of the sealing plug is inserted into the second end of the connecting tube; and
the connecting tube comprises a main section and a connecting section, the main section is connected to the housing through the connecting section, and a tube diameter of the connecting section is larger than a tube diameter of the main section.

12. The auxiliary heating apparatus of any one of claims 1 to 7, wherein
the connector is provided with a first limiting boss, which is capable of being in limit fit with the process door during use to limit a position of the connector in a direction perpendicular to a radial plane of a reaction chamber of the semiconductor heat treatment equipment.

13. A semiconductor heat treatment equipment, comprising:
a reaction chamber, which is provided with an open structure;
a process door, which is disposed at the open structure for sealing the reaction chamber; and
the auxiliary heating apparatus of any one of claims 1 to 12, the auxiliary heating apparatus being disposed at the process door and configured to heat a region inside the reaction chamber near the process door.

14. The semiconductor heat treatment equipment of claim 13, wherein the housing is disposed in the reaction chamber; and
the connector penetrates through the process door.

15. The semiconductor heat treatment equipment of claim 14, wherein the connector is provided with a first limiting boss, which is configured to be in limit fit with the process door during use to limit a position of the connector in a direction perpendicular to a radial plane of the reaction chamber.

16. The semiconductor heat treatment equipment of claim 15, wherein a buffer pad is disposed on an outer circumferential wall of a connecting tube and between the first limiting boss and the process door.

17. The semiconductor heat treatment equipment of claim 13, further comprising:
an insulation bucket, which has a first end connected to the process door and a second end configured to support a wafer boat;
wherein the housing is located on a side of the second end of the insulation bucket, and the connector penetrates through the insulation bucket.
